Europäisches Patentamt

European Patent Office

Office européen des brevets

(19)

(11) Publication number:

**0 377 867**

**A2**

# (12) EUROPEAN PATENT APPLICATION

(21) Application number: **89123434.6**

(22) Date of filing: **19.12.89**

(51) Int. Cl.5: **H01L 21/48**

(30) Priority: **11.01.89 US 297144**

(43) Date of publication of application:
**18.07.90 Bulletin 90/29**

(84) Designated Contracting States:
**DE FR GB**

(71) Applicant: **International Business Machines Corporation**
**Old Orchard Road**
**Armonk, N.Y. 10504(US)**

(72) Inventor: **Hurst, Jerry Elden., Jr.**
**1784 Marcy Lynn Court**
**San Jose California 95 124(US)**
Inventor: **Olson, Radley Wahl**
**20350 Stevens Creek Boulevard**
**Cupertino California 95 014(US)**
Inventor: **Wier-Cavalieri, Nancy Ann**
**6 Deller Road**
**Highland New York 12 528(US)**
Inventor: **Zollner, Allan**
**396 Grand Street**
**Newburgh New York 12 550(US)**

(74) Representative: **Oechssler, Dietrich, Dr. rer. nat.**
**IBM Deutschland GmbH Patentwesen und Urheberrecht Schönaicher Strasse 220**
**D-7030 Böblingen(DE)**

(54) Laser surface modification for seeding substrates.

(57) Method for selectively depositing metal onto ceramic and glass substrates by selectively melting a surface layer and thereafter contacting the melted surface with a seeding medium to deposit seed onto the melted surface. The seeded areas of the surface preferably are thereafter selectively plated with metal by contacting the surface with a suitable electroless plating solution.

## Laser Surface Modification for Seeding Substrates

This invention relates to methods for the selective seeding of ceramic and glass substrates for subsequent metallization.

The deposition of a metal onto a dielectric substrate, typically accomplished by electroplating from an electrolytic solution, is used in a variety of industries for a variety of purposes. In the microelectronics industry, there are continuing efforts to reduce the manufacturing cost of plated electronic components, such a integrated circuit (IC) chips and packaging substrates on which ICs are electrically mounted.

Packaging substrates are typically formed from oxide containing materials, such a ceramics, glass-ceramics and glasses. ICs typically have a top passivating dielectric fabricated from similar oxide containing materials. Conductor patterns are typically formed on the oxide containing surfaces of ICs and packaging substrates to provide a means for electrically inter-connecting components within the IC or substrate or for external electrical connection to the IC or substrate. State-of-the-art ICs and substrates have on the surface thereof conducting lines having thickness and width which can be submicron in dimension. As these dimensions become smaller the probability of having electrical opens increases. A single electrical open can render on IC or packaging substrate useless even though the IC or substrate has no other defects. An electrical open such as this which requires the component to be discarded, increases the cost of manufacture of nondefective components. Typically, electrical opens such as these are repaired.

The prior art teaches methods of plating metals onto substrates. Commonly known methods of selectively plating metal on a substrate employ masking to delineate patterns. The plating processes require multiple steps. Typically, a resist-like material is deposited on the substrate surface. The resist-like material is selectively removed to form a mask which selectively exposes the substrate surface; metal is plated onto the selectively exposed substrate surface. Finally, the mask is removed.

The prior art also teaches methods of selective plating of metal without the use of resist masks. Jap. Publication J6-1104-083-A of Hitachi describes a method of activating a surface of a substrate for selective metal plating thereon. The surface substrate is immersed in a solution and selectively irradiated with a laser. Thereafter, a metal is electrolessly plated into the selectively irradiated parts of the substrate surface.

U.S. Patent No. 4,239,789 to Blum et al. describes a method for maskless plating onto a substrate. The substrate is immersed in a plating solution and selectively irradiated with light which results in metal from the solution plating onto the irradiated parts of the substrate.

U.S. Patent No. 4,574,095 to Baum et al. describes a process for depositing Pd seed onto a substrate by irradiating the substrate with light while the substrate is contacted with an organopalladium vapor. The vapor is thermally or photochemically decomposed by the light to deposit the seed.

U.S. Patent No. 4,578,157 and U.S. Patent No. 4,578,155 describe methods of plating by irradiating with a laser, a substrate in a plating solution.

U.S. Patent No. 4,615,907 to Boeke et al. describes a process for plating onto poly (arylene sulfide) substrates. The substrate is first selectively irradiated with a laser to change the irradiated part of the surface with respect to the nonirradiated part. The intensity of the radiation is sufficient to render the substrate surface water wettable, but not enough to cause degradation of the polymer surface. The irradiated substrate is either contacted with a plating solution to plate metal onto the irradiated surface or a catalyst, e.g., Pd/Sn, for subsequent electroless plating.

Boeke et al. teaches irradiating with a laser a specific polymer at low laser power to alter the surface roughness without degrading the surface to improve the adhesion of plated metal coatings. As described in the example both treated and nontreated substrates are plated. The effect of the laser treatment is to improve the adhesion of the plated metal.

U.S. Patent No. 4,348,263 to Draper et al. describes a method of minimizing surface inhomogeneties of a metal surface by using a laser or electron beam to melt a thin surface layer. This alters the grain structure and surface smoothness of the metal surface and enhances the grain structure and surface smoothness of the subsequently plated protective metal layers. The metal surfaces can be plated upon without the surface melting. The surface melting enhances the quality of the metal plated on the metal surface.

Neither Boeke et al. nor Draper et al. teaches or suggests selectively melting a ceramic or glass substrate prior to contacting the substrate with a seeding medium to result in seed being deposited onto the substrate.

It is an object of the invention to selectively prepare a ceramic or glass substrate surface for seeding.

It is another object of the present invention to selectively prepare an oxide containing surface for seeding.

These objects are achieved by methods as disclosed in claims 1, 5, 6 and 8.

Quite surprisingly is has been found, that for a ceramic or glass substrate, in particular for an oxide containing substrate, a thin surface layer can be selectively melted (for example, by a focused laser beam) and thereafter the substrate is placed in a seeding solution. It has been found that the seed is selectively deposited only onto those parts of the substrate which have been selectively melted. According to the present invention seed or metal is not deposited with a laser as it is according to the Blum et al. patent, the Hitachi publication and the vapor-phase method of Baum et al.

In accordance with a more particular aspect of the present invention, the ceramic or glass surface is an oxide containing surface.

In accordance with another more particular aspect of the present invention, the substrate surface is selectively melted by a focused optical beam.

In accordance with another more particular aspect of the present invention, a metal is electrolessly deposited onto those parts of the substrate surface on which seed is deposited.

Other advantageous embodiments of the inventive methods are disclosed in the subclaims.

These and other objects, features and advantages will be apparent from the following more particular description of the preferred embodiments.

In accordance with this invention a method is provided for preparing ceramic and glass substrates, in particular, oxide containing ceramic, glass and glass-ceramic substrates, for metallization by plating without the requirement of preparing the substrate with chemical agents, prior to contacting the substrate with a seeding medium. Typical substrates are ceramics, glass-ceramics and glasses. An example of a ceramic is alumina. Examples of glass ceramics are spodumine mullite and cordierite-type glass ceramics. An example of a glass is a borosilicate glass. The surface of the substrate is selectively melted. It has been found that the melted region can have a thickness as thin as about 1 micron. It is believed that the melted region thickness can be as thin as 0.03 to 0.05 microns. The melted regions do not have to be continuous. Islands of melted surface layer are sufficient to practice the present invention. The islands are sufficiently closely spaced so that when metal is plated onto seed deposited onto the islands, the plated metal joins together between islands.

The preferred way to melt the substrate surface is with an optical beam which is sufficiently focused to melt a thin skin on the substrate surface. Commonly available lasers can be used for the optical beam and have been found to readily form melted regions of from about 1 micron to about 10 microns. The optical beam preferably has a wave length which is absorbed at the surface to cause a thin surface layer to melt. The more efficiently the optical beam is absorbed, the lower the beam power and focusing required to cause the surface layer to melt. Optical beams sufficient to practice the methods of this invention can be provided by laser beams. Selective areas of the substrate surface can be melted by focusing the optical beam and scanning the beam using conventional apparatus to melt a predetermined pattern at the substrate surface. The wavelength of light selected depends on the substrate being irradiated. A wavelength is chosen which will be absorbed by the substrate surface. It is within the skill of the art to choose an appropriate wavelength for a particular substrate. It is also within the skill of the art to choose an appropriate optical system to focus the optical beam to achieve a sufficient spot size and power density for the particular wavelength of light used. After the substrate surface is selectively melted, the melted regions are contacted with a seeding medium. Typical seeding media are chloride solutions, chlorides of platinum metals, e.g., Ru, Rh, Os and Ir, $PdCl_2$ and $AuCl_3$. This list is exemplary only and not limiting. The preferred seeding medium is a palladium chloride solution which deposits a palladium catalyst seed onto the laser-written areas. Metal can be electrolessly deposited onto the seeded areas using commonly used plating solutions such as plating solutions of copper, nickel, gold, the platinum group metals and cobalt. This list is exemplary and not limiting. The preferred plating solution is a nickel plating solution.

## Example

Laser pulses of 10.6 $\mu$m wavelength and 85-100 $\mu$s duration were generated by a slow axial flow $CO_2$ laser at a repetition rate of 1-2 kHz with the pulse energy adjusted to yield a total laser beam power of 4-8W. This beam was focused to a spot size of 50-100 $\mu$m on the surface of an alumina sheet sample. The sample was moved by a motorized translation stage under the focused beam at a rate of 2.54 to 5.08 cm, which created visible, narrow, melted, visibly continuous lines on the sample surface. Approximately 24 or more hours later the laser-written alumina sample was cleaned by a water jet (although KOH or KFe (CN)$_6$ solutions can also be used), rinsed in deionized water, and placed in a $PdCl_2$ seeding solution (consisting of 0.1 wt % $PdCl_2$ and 1 ml/l concentrated HCl in deionized water) for a period of about 1 min. It was then placed in 5 volume-percent HCl for 4 minutes and in hot running deionized water for 4 minutes. The wet substrates are transferred to an electroless Ni plating bath for 55 minutes to deposit about 5 $\mu$m Ni with 0.04 % boron.

Nickel plated readily on the narrow laser-written lines on the sample and did not plate elsewhere. The plated lines exhibited very good adhesion to the alumina surface.

The electroless nickel plating bath contains about 50 grams/liter nickel acetate, about 25 g/l lactic acid, about 25 g/l sodium citrate, about 2.5 g/l dimethylamine borane, about .1 g/l non foaming wetting agent and about 1.5 mg/l thiodiglycolic acid.

While the invention has been illustrated and described with respect to preferred embodiments, it is to be understood that the invention is not limited to the precise constructions herein disclosed, and the right is reserved to all changes and modifications coming within the scope of the invention as defined in the appended claims.

## Claims

1. Method for preparing a substrate, selected from a ceramic and glass substrate, for subsequent metallization comprising:
selectively melting the surface of seed substrate; and
thereafter contacting at least the selectively melted parts of said surface with a seeding medium to deposit seed onto said melted parts.

2. Method according to claim 1, wherein said substrate is an oxide containing substrate selected from the group consisting of a ceramic, glass-ceramic and a glass.

3. Method according to claim 1 or 2, wherein said melting is done by an optical beam.

4. Method according to any one of claims 1 to 3, wherein said medium is a seeding solution, from which seed is disposed on said melted parts.

5. Method for seeding an oxide containing substrate comprising:
writing a pattern on said substrate with a focused optical beam; and
thereafter contacting at least said pattern with a seeding medium to deposit seed onto said pattern.

6. Method for metallizing a substrate selected from a ceramic and glass substrate comprising:
writing a pattern on said substrate with a focused optical beam; and
thereafter contacting at least said pattern with a seeding medium.

7. Method according to any one of claims 4 to 6, wherein the seed contained in said seeding solution is selected from the group consisting of Cu, Ni and Pd, where in the latter case said seeding solution is preferably a palladium chloride solution.

8. Method for metallizing an alumina substrate comprising:
writing a pattern on said substrate with a focused optical beam, said beam having a wavelength of about 10.6 $\mu$m and power of from about 4 to 8 W and spot size of from about 50 to about 100 $\mu$m; and
thereafter, contacting at least said pattern with a palladium chloride solution.

9. Method according to any one of claims 1 to 8, wherein said optical beam is a laser beam.

10. Method of claim 1, further including electrolessly depositing a metal onto said seed with said electrolessly deposited metal being selected preferably from the group consisting of Ag, Au, Ni, Cu, Co, and the platinum group metals.

11. Method according to any one of claims 1 to 10, wherein only closely spaced islands of surface layer are melted.

12. Method according to claim 11, wherein the metal plated onto seed joins together between islands.